# EUROPEAN PATENT APPLICATION

(11) **EP 1 672 009 A1**
(43) Date of publication of application: **21.06.2006**
(21) Application number: 05023745.2
(22) Date of filing: 31.10.2005
(51) Int. Cl.: C08J 5/18, C08K 3/00, C08K 3/22, C08K 3/38

(54) **Thermally conductive polyimide film composites having high thermal conductivity useful in an electronic device**

(30) Priority: 15.12.2004 US 12914
(71) Applicant: E.I. du Pont de Nemours and Company, Wilmington, DE 19898 (US)
(72) Inventor: Meloni, Paul Arthur, League City, Texas 77573 (US)
(74) Representative: Bailey, Lindsey

(57) **Abstract**

In electronic devices, heat removal is an important consideration of any device designer. Thermally conductive, high-temperature polyimide composites are disclosed herein which are generally useful as a dielectric layer in an electronic device, or a precursor metal-laminate, where the dielectric is layered on one side (or on both sides) with a metal. The polyimide composites of the present invention contain dispersed therein thermally conductive filler particles at a weight percent between 40 and 85 % weight percent. These film composites have good dielectric strength, good thermal conductivity, and optionally good adhesivity.

## Description

### FIELD OF THE INVENTION

The present invention is directed to thermally conductive polyimide composites useful as a sheet adhesive, and/or a base substrate, in an electronic device or similar-type application. These electronic devices can be made from a sheet laminate comprising a highly filled, polyimide composite layer and a metal layer where the metal is on one side, or two sides, of the polyimide composite layer. More specifically, the polyimide composite layer of the present invention can be used as a dielectric. The polyimide comprises an inorganic filler material dispersed in a polyimide binder in an amount from 40 to 85 weight percent.

### BACKGROUND OF THE INVENTION

Metal oxide particles, particularly boron, alumina, aluminum-nitride, and boron-nitride, are known to have good thermal conductivity and are used as fillers in many polymer binders, including polyimides. Sub-micron aluminum oxide particles, for example are commonly used as a filler material in commercial applications requiring thermal conductivity in a polyimide sheet. However, electronic devices generate more power and more heat requiring thermal management to be more important. Therefore a need exists for a polyimide composite having higher thermal conductivity and/or reduce thermal impedance.

U.S. Pat. No. 6,208,631 to Fraivillig teaches an improved thermal conductivity laminate using a thermally conductive polyimide film comprising aluminum oxide particles (dispersed in the polyimide matrix), the composite matrix being layered onto a metal substrate using a separate adhesive layer. However, the polyimide composites typically disclosed are composites containing less than about 40 weight percent of thermally conductive filler. As such, these composites sometimes have too low thermal conductivity to be useful in some electronics applications.

U.S. Pat. No. 6,410,971 to Otey discloses a thermoelectric module device employing a.polyimide film having no thermally conductive filler material therein where the unfilled polyimide film is used to conduct heat (relatively poorly) from an adjacent ceramic substrate.

### SUMMARY OF THE INVENTION

The present invention is directed to polyimide film composites having a good thermal conductivity. These composite films are particularly useful as a thermally conductivity dielectric layer in an electronic device.

The composites of the present invention comprise a polyimide binder having dispersed therein thermally conductive filler particles. The weight loading of filler component in the polyimide binder component is between and including any two of the following numbers 40, 45, 50, 55, 60, 65, 70, 75, 80, or 85, weight percent.

The polyimide binders of the present invention can have a glass transition temperature of between and including any two of the following numbers, 250, 240, 230, 220, 210, 200, 190, 180, 170, 160, 150, 140, 130, 120, 110 and 100°C or can have a glass transition temperature between 250, 270, 290, 310, 330, 350, 370, 390, 410, 430, 450, 470, 490, 510, 530, or 550°C.

The polyimide composites of the present invention are derived from a polyimide component and a thermally conductive filler component. The polyimide component of the present invention is derived from a dianhydride component and a diamine component where the dianhydride component is typically any aromatic, aliphatic, or cycloaliphatic dianhydride, and where the diamine component is either an aromatic diamine, an aliphatic diamine, a cycloaliphatic diamine, or a combination of these.

The thermally conductive fillers of the present invention (i.e. those fillers dispersed in the polyimide binder material) generally have an average particle size (dispersed in the polymer binder) in a range between and including any two of the following sizes: 100, 125, 150, 175, 200, 250, 300, 350, 400, 450, 500, 1000, 2000, 3000, 4000, and 5000 nanometers, where at least 80, 85, 90, 92, 94, 95, 96, 98, 99 or 100 weight-percent of the dispersed filler is within the above defined size range(s). These fillers are present in the polyimide composite in an amount ranging from 40, 45, 50, 55, 60, 65, 70, 75, 80, and 85 weight percent.

The thermally conductive fillers of the present invention are typically selected from the group comprising, aluminum oxide, silica, boron nitride, boron nitride coated aluminum oxide, granular alumina, granular silica, fumed silica, silicon carbide, aluminum nitride, aluminum oxide coated aluminum nitride, titanium dioxide, dicalcium phosphate, barium titanate and combinations thereof.

The polyimide film composites of the present invention are typically in the form of a thin film having a thickness ranging from about 2, 5, 10, 15, 20, 25, 30, 35, 40, 50, 60, 70, 80, 90, 100, 150, 200, 250 and 300 microns.

The thermal conductivity of the polyimide film composites of the present invention is generally between and including any two of the following numbers 0.5, 0.6, 0.7, 0.8, 0.9, 1.0, 1.1, 1.2, 1.3, 1.4, 1.5, 1.6, 1.7, 1.8, 1.9, 2.0, 4.0, 6.0, 8.0, 10.0, 20.0, 50.0, 100, 150 and 200 watts/(meter*K).

The composites of the present invention are excellent dielectrics that can be useful in forming a polyimide-metal laminate, or may also be used as a stand-alone film in other designs requiring good thermal conductivity from a dielectric.

Generally, the thermally conductive polyimide film composites of the present invention are useful as a single layer base substrate (a dielectric) in an electronic device requiring good thermal conductivity of the dielectric material. Examples of such electronic devices include (but are not limited to) thermoelectric modules, thermoelectric coolers, DC/AC and AC/DC inverters, DC/DC and AC/AC converters, power amplifiers, voltage regulators, igniters, light emitting diodes, IC packages, and the like.

### DETAILED DESCRIPTION OF THE PREFERRED EMBODIMENT(S)

Overview. The polyimide composites of the present invention comprise (i.) a polyimide binder component, and (ii.) an inorganic filler component capable of conducting thermal energy. These components will be described individually, then described together as a composite material.

Polyimide Binders. Useful high dielectric strength polyimide binders of the present invention are derived from a dianhydride component (or the corresponding diacid-diester, diacid halide ester, or tetra-carboxylic acid derivative of the dianhydride) and a diamine component. The dianhydride component is typically any aromatic, aliphatic, or cycloaliphatic dianhydride. The diamine component is typically any aromatic diamine, aliphatic diamine, or cycloaliphatic diamine.

Useful dianhydrides of the present invention include aromatic dianhydrides. These aromatic dianhydrides include, (but are not limited to),
1. pyromellitic dianhydride (PMDA);
2. 3,3',4,4'-biphenyl tetracarboxylic dianhydride (BPDA);
3. 3,3',4,4'-benzophenone tetracarboxylic dianhydride (BTDA);
4. 4,4'-oxydiphthalic anhydride (ODPA);
5. 3,3',4,4'-diphenylsulfone tetracarboxylic dianhydride (DSDA);
6. 2,2-bis(3,4-dicarboxyphenyl) 1,1,1,3,3,3-hexafluoropropane dianhydride (6FDA);
7. 4,4'-(4,4'-isopropylidenediphenoxy)bis(phthalic anhydride) (BPADA);
8. 2,3,6,7-naphthalene tetracarboxylic dianhydride;
9. 1,2,5,6-naphthalene tetracarboxylic dianhydride;
10. 1,4,5,8-naphthalene tetracarboxylic dianhydride;
11. 2,6-dichloronaphthalene-1,4,5,8-tetracarboxylic dianhydride;
12. 2,7-dichloronaphthalene-1,4,5,8-tetracarboxylic dianhydride;
13. 2,3,3',4'-biphenyl tetracarboxylic dianhydride;
14. 2,2',3,3'-biphenyl tetracarboxylic dianhydride;
15. 2,3,3',4'-benzophenone tetracarboxylic dianhydride;
16. 2,2',3,3'-benzophenone tetracarboxylic dianhydride;
17. 2,2-bis(3,4-dicarboxyphenyl) propane dianhydride;
18. 1,1-bis(2,3-dicarboxyphenyl) ethane dianhydride;
19. 1,1-bis(3,4-dicarboxyphenyl) ethane dianhydride;
20. bis-(2,3-dicarboxyphenyl) methane dianhydride;
21. bis-(3,4-dicarboxyphenyl) methane dianhydride;
22. 4,4'-(hexafluoroisopropylidene) diphthalic anhydride;
23. bis-(3,4-dicarboxyphenyl) sulfoxide dianhydride;
24. tetrahydrofuran-2,3,4,5-tetracarboxylic dianhydride;
25. pyrazine-2,3,5,6-tetracarboxylic dianhydride;
26. thiophene-2,3,4,5-tetracarboxylic dianhydride;
27. phenanthrene-1,8,9,10-tetracarboxylic dianhydride;
28. perylene-3,4,9,10-tetracarboxylic dianhydride;
29. bis-1,3-isobenzofurandione;
30. bis-(3,4-dicarboxyphenyl) thioether dianhydride;
31. bicyclo[2,2,2]oct-7-ene-2,3,5,6-tetracarboxylicdianhydride;
32. 2-(3',4'-dicarboxyphenyl) 5,6-dicarboxybenzimidazole dianhydride;
33. 2-(3',4'-dicarboxyphenyl) 5,6-dicarboxybenzoxazole dianhydride;
34. 2-(3',4'-dicarboxyphenyl) 5,6-dicarboxybenzothiazole dianhydride;
35. bis-(3,4-dicarboxyphenyl) 2,5-oxadiazole 1,3,4-dianhydride;
36. bis-2,5-(3',4'-dicarboxydiphenylether) 1,3,4-oxadiazole dianhydride;
37.bis-2,5-(3',4'-dicarboxydiphenylether) 1,3,4-oxadiazole dianhydride;
38.5-(2,5-dioxotetrahydro)-3-methyl-3-cyclohexene-1,2-dicarboxylic anhydride;
39. trimellitic anhydride 2,2-bis(3',4'-dicarboxyphenyl)propane dianhydride;
40. 1,2,3,4-cyclobutane dianhydride;
41. 2,3,5-tricarboxycyclopentylacetic acid dianhydride;
42. their acid ester and acid halide ester derivatives;
43. and the like.

Useful aromatic diamines of the present invention include, but are not limited to,
1. 2,2 bis-(4-aminophenyl) propane;
2. 4,4'-diaminodiphenyl methane;
3. 4,4'-diaminodiohenyl sulfide (4,4'-DDS);
4. 3,3'-diaminodiphenyl sulfone (3,3'-DDS);
5. 4,4'-diaminodiphenyl sulfone;
6. 4,4'-diaminodiphenyl ether (4,4'-ODA);
7. 3,4'-diaminodiphenyl ether (3,4'-ODA);
8. 1,3-bis- (4-aminophenoxy) benzene (APB-134 or RODA);
9. 1,3-bis- (3-aminophenoxy) benzene (APB-133);
10. 1,2-bis- (4-aminophenoxy) benzene;
11. 1,2-bis- (3-aminophenoxy) benzene;
12. 1,4-bis-(4-aminophenoxy) benzene;
13. 1,4-bis-(3-aminophenoxy) benzene;
14. 1,5-diaminonaphthalene;
15. 1,8-diaminonaphthalene;
16. 2,2'-bis(trifluoromethyl)benzidine;
17. 4,4'-diaminodiphenyldiethylsilane;
18. 4,4'-diaminodiphenylsilane;
19. 4,4'-diaminodiphenylethylphosphine oxide;
20. 4,4'-diaminodiphenyl-N-methyl amine;
21. 4,4'-diaminodiphenyl-N-phenyl amine;
22. 1,2-diaminobenzene (OPD);
23. 1,3-diaminobenzene (MPD);
24. 1,4-diaminobenzene (PPD);
25. 2,5-dimethyl-1,4-diaminobenzene;
26. 2-(trifluoromethyl)-1,4-phenylenediamine;
27. 5-(trifluoromethyl)-1,3-phenylenediamine;
28. 2,2-Bis[4-(4-aminophenoxy)phehyl]-hexafluoropropane (BDAF);
29. 2,2-bis(3-aminophenyl) 1,1,1,3,3,3-hexafluoropropane;
30. benzidine;
31. 4,4'-diaminobenzophenone;
32. 3,4'-diaminobenzophenone;
33. 3,3'-diaminobenzophenone;
34. m-xylylene diamine;
35. bisaminophenoxyphenylsulfone;
36. 4,4'-isopropylidenedianiline;
37. N,N-bis-(4-aminophenyl) methylamine;
38. N,N-bis-(4-aminophenyl) aniline
39. 3,3'-dimethyl-4,4'-diaminobiphenyl;
40. 4-aminophenyl-3-aminobenzoate;
41. 2,4-diaminotoluene;
42. 2,5-diaminotoluene;
43. 2,6-diaminotoluene;
44. 2,4-diamine-5-chlorotoluene;
45. 2,4-diamine-6-chlorotoluene;
46. 4-chloro-1,2-phenylenediamine;
47. 4-chloro-1,3-phenylenediamine;
48. 2,4-bis-(beta-amino-t-butyl) toluene;
49. bis-(p-beta-amino-t-butyl phenyl) ether;
50. p-bis-2-(2-methyl-4-aminopentyl) benzene;
51. 1-(4-aminophenoxy)-3-(3-aminophenoxy) benzene;
52. 1-(4-aminophenoxy)-4-(3-aminophenoxy) benzene;
53. 2,2-bis-[4-(4-aminophenoxy)phenyl] propane (BAPP);
54. bis-[4-(4-aminophenoxy)phenyl] sulfone (BAPS);
55. 2,2-bis[4-(3-aminophenoxy)phenyl] sulfone (m-BAPS);
56. 4,4'-bis-(aminophenoxy)biphenyl (BAPB);
57. bis-(4-[4-aminophenoxy]phenyl) ether (BAPE);
58. 2,2'-bis-(4-aminophenyl)-hexafluoropropane (6F diamine);
59. bis(3-aminophenyl)-3,5-di(trifluoromethyl)phenylphosphine oxide
60. 2,2'-bis-(4-phenoxy aniline) isopropylidene;
61. 2,4,6-trimethyl-1,3-diaminobenzene;
62. 4,4'-diamino-2,2'-trifluoromethyl diphenyloxide;
63. 3,3'-diamino-5,5'-trifluoromethyl diphenyloxide;
64. 4,4'-trifluoromethyl-2,2'-diaminobiphenyl;
65. 4,4'-oxy-bis-[(2-trif)uoromethy) benzene amine];
66. 4,4'-oxy-bis-[(3-trifluoromethyl) benzene amine];
67. 4,4'-thio-bis-[(2-trifluoromethy) benzene-amine];
68. 4,4'-thiobis-[(3-trifluoromethyl) benzene amine];
69. 4,4'-sulfoxyl-bis-[(2-trifluoromethyl) benzene amine;
70. 4,4'-sulfoxyl-bis-[(3-trifluoromethyl) benzene amine];
71. 4,4'-keto-bis-[(2-trifluoromethyl)benzene amine];
72. 9,9'-bis(4-aminophenyl)fluorene;
73. 1,3-diamino-2,4,5,6-tetrafluorobenzene;
74. 3,3'-bis(trifluoromethyl)benzidine;
75. and the like.

Useful aliphatic diamines of the present invention, used alone or in conjunction with either an aromatic diamine, include but are not limited to 1,6-hexamethylene diamine, 1,7-heptamethylene diamine, 1,8-octamethylenediamine, 1,9-nonamethylenediamine, 1,10-decamethylenediamine (DMD), 1,11-undecamethylenediamine, 1,12-dodecamethylenediamine (DDD), 1,16-hexadecamethylenediamine, 1,3-bis(3-aminopropyl)-tetramethyldisiloxane, isophoronediamine, and combinations thereof.

The dianhydride and diamine components of the present invention are particularly selected to provide the polyimide binder with certain desirable properties. One such property is for the polyimide binder to have a certain glass transition temperature (Tg). One useful Tg range can be between and including any two of the following numbers, 250, 240, 230, 220, 210, 200, 190, 180, 170, 160, 150, 140, 130,120, 110 and 100°C if for example good adhesivity of the binder is required. Another useful range, if adherability is less important than other properties, is from 550, 530, 510, 490, 470, 450, 430, 410, 390, 370, 350, 330, 310, 290, 270, and 250°C. Not all of the dianhydrides and diamines listed above will form either a low-Tg polyimide binder or a high-Tg binder. As such, the selection of which dianhydride, and which diamine components, is needed is an important issue for customizing the final properties of the polymer binder.

In one embodiment of the present invention, p-phenylene diamine is used in combination with 4,4'-ODA as a second diamine. In this embodiment, a combination of BPDA and PMDA is used as the dianhydride component to form the polyimide binder. In another embodiment, PMDA is used with 4,4-ODA to form the polyimide. In this embodiment, a precursor to the polyimide binder component (i.e. a polyamic acid) was homogeneously blended with about 50 weight-percent aluminum oxide filler. The resulting mixed polymer was thermally converted to a 1-mil thick, filled-polyimide film composite. The film composite had a thermal conductivity of about 0.7 watts/(meter*K), and a Tg of greater than 350°C.

In another embodiment of the present invention useful dianhydrides include BPADA, DSDA, ODPA, BPDA, BTDA, 6FDA, and PMDA or mixtures thereof. These dianhydrides are readily commercially available and generally provide acceptable performance. One noteworthy dianhydride is BPADA because it can produce a polyimide having excellent adhesivity and good flex life while also having a relatively low, moisture absorption coefficient.

In one embodiment of the present invention, the polyimide is synthesized by first forming a polyimide precursor (typically a polyamic acid solution). The polyamic acid is created by reacting (in a solvent system) one or more dianhydride monomers with two or more diamine monomers (one being a polysiloxane diamine). So long as the thermally conductive filler is sufficiently dispersible in the polyamic acid solution, the filler can be dispersed prior to, during, or after the polyamic acid solution is created. This is generally true at least until the imidization of the polymer (i.e. solvent removal and curing) increases viscosity beyond the point where a filler material can be adequately dispersed within the binder.

Useful organic solvents, for the synthesis of the polyimides of the present invention, are preferably capable of dissolving the polyimide precursor materials. Such a solvent should also have a relatively low boiling point, such as below 225°C, so the polyimide can be dried at moderate (i.e., more convenient and less costly) temperatures. A boiling point of less than 210, 205, 200, 195, 190, or 180°C is preferred.

Solvents of the present invention may be used alone or in combination with other solvents (i.e., cosolvents). Useful organic solvents include: N-methylpyrrolidone (NMP), dimethyl-pyrrolidin-3-one, dimethylacetamide (DMAc), N,N'-dimethyl-formamide (DMF), dimethyl sulfoxide (DMSO), tetramethyl urea (TMU), hexamethylphosphoramide, dimethylsulfone, tetramethylene sulfone, gamma-butyrolactone, and pyridine. In one embodiment, preferred solvents include N-methylpyrrolidone (NMP) and dimethylacetamide (DMAc).

Co-solvents can also be used generally at about five to 50 weight-percent of the total solvent. Useful co-solvents include xylene, toluene, benzene, diethyleneglycol diethyl ether, 1,2-dimethoxyethane (monoglyme), diethylene glycol dimethyl ether (diglyme), 1,2-bis-(2-methoxyethoxy) ethane (triglyme), bis [2-(2-methoxyethoxy)ethyl)] ether (tetraglyme), bis-(2-methoxyethyl) ether, tetrahydrofuran, propylene glycol methyl ether, propylene glycol methyl ether acetate, "Cellosolve™" (ethylene glycol ethyl ether), butyl "Cellosolve™" (ethylene glycol butyl ether), "Cellosolve™ acetate" (ethylene glycol ethyl ether acetate), and "butyl Cellosolve™ acetate" (ethylene glycol butyl ether acetate).

Ultimately, the precursor (polyamic acid) is converted into a high-temperature polyimide material having a solids content greater than about 99.5 weight percent. At some point in this process, the viscosity of the binder is increased beyond the point where the filler material can be blended with polyimide precursor. Depending upon the particular embodiment herein; the viscosity of the binder can possibly be lowered again by solvating the material, perhaps sufficiently enough to allow dispersion of the filler material into the binder.

Polyamic acid solutions can be converted to high temperature polyimides using processes and techniques commonly known in the art such as heat or conventional polyimide conversion chemistry. Such polyimide manufacturing processes have been practiced for decades. The amount of public literature on polyimide manufacture is legion and hence further discussion herein is unnecessary. Any conventional or non-conventional polyimide manufacturing process can be appropriate for use in accordance with the present invention provided that a precursor material is available having a sufficiently low viscosity to allow filler material to be mixed. Likewise, if the polyimide is soluble in its fully imidized state, filler can be dispersed at this stage prior to forming into the final composite.

Thermally Conductive Filler Component. The thermally conductive filler component of the present invention can be an inorganic material, sometimes a metal oxide, having an average size (dispersed within the polyimide binder material) in a range between (and including) any two of the following sizes: 50, 55, 60, 65, 70, 75, 80, 85, 90, 95, 100, 125, 150, 175, 200, 250, 300, 350, 400, 450, 500 and 5,000 nanometers, where at least 80, 85, 90, 92, 94, 95, 96, 98, 99 or 100 percent of the dispersed filler is within the above size range(s). Filler size can be determined by a laser particle analyzer, such as a Horiba® laser particle analyzer when the filler is dispersed in an organic solvent (optionally with the aid of a dispersant, adhesion promoter, and/or coupling agent).

In some embodiments of the present invention, if the mean particle size is smaller than 50 nanometers, the filler particles can tend to agglomerate, or become unstable, in the organic solvents preferably used in polyimide manufacturing. In another instance, if the mean particle size of the agglomerated particles exceeds 5,000 nanometers the dispersion of the filler component in the polyimide binder may be too non-homogeneous (or unsuitably large for the thickness of the composite). A relatively non-homogenous dispersion of the filler component in the binder can result in poor mechanical elongation of the composite film, poor flex life of the film, and/or low dielectric strength.

The thermally conductive filler component of the present invention is selected primarily to provide the film composite with good thermal conductivity. Since alumina is widely accepted in the industry as a useful thermally conductive filler material (especially in polymer binders), it is particularly mentioned herein. However, the present invention does anticipate the use of other fillers as thermally conductive fillers. These fillers include (but not limited to) silica, boron nitride, boron nitride coated aluminum oxide, granular alumina, granular silica, fumed silica, silicon carbide, aluminum nitride, aluminum oxide coated aluminum nitride, titanium dioxide, barium titanate and combinations thereof.

The weight loading of filler component in the polyimide binders of the present invention is generally between and including any two of the following numbers 40, 45, 50, 55, 60, 65, 70, 75, 80, or 85, weight percent. At these loading levels, the thermal conductivity of the composite polyimide films can be between (and including) any two of the following numbers 0.5, 0.6, 0.7, 0.8, 0.9, 1.0, 1.1, 1.2, 1.3, 1.4, 1.5, 1.6, 1.7, 1.8, 1.9, 2.0, 4.0, 6.0, 8.0, 10.0, 20.0, 50.0, 100, 150 and 200 watts/(meter*K) in a film having a thickness between (and including) any two of the following numbers 2, 5, 10, 15, 20, 25, 30, 35, 40, 50, 60, 70, 80, 90, 100, 150, 200, 250 and 300 microns.

Typically, the thermally conductive fillers of the present invention generally can require extensive milling and filtration to breakup unwanted particle agglomeration as is typical when attempting to disperse nano-sized conventional fillers into a polymer matrix. Such milling and filtration can be costly and may not be capable of removing all unwanted agglomerates. Indeed in one embodiment, the thermally conductive filler is dispersible, and suspendable, at 35 weight-percent in dimethylacetamide solvent. After dispersing and suspending the filler into the solvent (with a high shear mechanical force) less than 15, 10, 8, 6, 4, 2 or 1 weight-percent of the filler precipitated out of solution when kept at rest at 20°C for 72 hours.

Incorporating the Filler into a Polyimide Matrix. The thermally conductive polyimide sheet adhesive films of the present invention can be produced by combining diamine and dianhydride monomers together, in the presence of a polar aprotic solvent, to form a polyamic acid solution (also called a polyamic acid solution). The dianhydride and diamine monomers are typically combined in a molar ratio of aromatic dianhydride monomer to aromatic diamine monomer of from about 0.90 to 1.10 Molecular weight of the polyamic acid can be adjusted by adjusting the molar ratio of the dianhydride and diamine monomers.

In one embodiment, the polyamic acid solution contains polyamic acid dissolved in a polar aprotic solvent at a concentration in a range between (and including) any two of the following percentages: 5, 10, 12, 15, 20, 25, 27, 30, 40, 45, 50, 55, or 60 (%) percent by weight. In one embodiment, the solvent content of the polyamic acid solution is in a range of from about 10, 12, 14, 16, 18, 20, or 22, to about 24, 26, 28 or 30 weight (%) percent solvent.

In one embodiment, nano-sized filler in accordance with the present invention (i.e., alumina oxide particles) are first dispersed in a solvent to form a slurry. The slurry is then dispersed in the polyamic acid precursor solution. This mixture is referred to herein as a filled polyamic acid casting solution. The concentration of filler to polyimide (in the final composite film) is typically in the range of 40, 45, 50, 55, 60, 65, 70, 75, 80 or 85 (%) percent by weight. As the concentration of the filler increases, the thermal conductivity of the composite polyimide also increases.

The filled polyamic acid casting solution is typically a blend of a preformed polyamic acid solution and filler. Here the filler is present in a concentration range from about 1, 3, 5, 7, 9 or 10 weight (%) percent to about 15, 20, 25, 30, 35, 40, 45 or 50 (%) weight percent or greater. In one embodiment, the filler is first dispersed in the same polar aprotic solvent used to make the polyamic acid solution (e.g. DMAc). Optionally, a small amount of polyamic acid solution may be added to the filler slurry to either increase the viscosity of the slurry, improve dispersion, or stabilize the slurry from unwanted particles agglomeration.

In one embodiment, the filler slurry is blended with a polyamic acid solution to form the filled polyamic acid casting solution. This blending operation can include high sheer mixing. In this embodiment, if the filler is present beyond 85 weight-percent in the final film, the film can be too brittle and may not be sufficiently flexible to form a freestanding, mechanically tough, flexible sheet. Moreover, if the filler is present at a level of less than 40 weight-percent, the films formed therefrom may not be sufficiently thermally conductive.

The polyamic acid casting solution mentioned above can optionally further comprise additional additives, including processing aids (e.g., oligomers), antioxidants, light stabilizers, flame retardant additives, anti-static agents, heat stabilizers, ultraviolet absorbing agents, other organic or inorganic fillers or various reinforcing agents. Common inorganic fillers include corona resistant fillers, like fumed metal oxides, and electrically conductive fillers like metals. Other common fillers include silicon carbide, diamond, dicalcium phosphate, polyaniline, polythiophene, polypyrrole, polyphenylenevinylene, polydialkylfluorenes, carbon black, graphite, and electrically conductive polymers.

In one embodiment of the present invention, the polyamic acid casting solution is cast, or applied onto, a support such as an endless metal surface or rotating drum. A wet film then formed by heating the solution to remove some of the solvent. The wet film, sometimes called a 'green' film is converted into a self-supporting film by baking at an appropriate temperature where the solids are from 60, 65, 70, 75, 80, 85, and 90 weight percent. The green film is separated from the support and cured in a tentering process with continued thermal and/or radiation curing. This process can produce a film that is a relatively highly cured polyimide film having a weight-percent solids of above 98.5% or higher.

Other useful methods for producing polyimide films in accordance with the present invention can be found in U.S. Patent Nos. 5,166,308 and 5,298,331 and are incorporated by reference into this specification for all teachings therein. Numerous variations are also possible such as:
(a) A method wherein the diamine monomers and dianhydride monomers are preliminarily mixed together and then the mixture is added in portions to a solvent while stirring.
(b) A method wherein a solvent is added ao a stirring mixture of diamine and dianhydride monomers (contrary to (a) above).
(c) A method wherein diamines are exclusively dissolved in a solvent and then dianhydrides are added thereto at such a ratio as allowing to control the reaction rate.
(d) A method wherein the dianhydride monomers are exclusively dissolved in a solvent and then amine components are added thereto at such a ratio to allow control of the reaction rate.
(e) A method wherein the diamine monomers and the dianhydride monomers are separately dissolved in solvents and then these solutions are mixed in a reactor.
(f) A method wherein the polyamic acid with excessive amine component and another polyamic acid with excessive anhydride component are preliminarily formed and then reacted with each other in a reactor, particularly in such a way as to create a non-random or block copolymer.
(g) A method wherein a specific portion of the amine components and dianhydride components are first reacted and then residual dianhydride monomer is reacted, or vice versa.
(h) A method wherein the filler particles are dispersed in a solvent and then injected into a stream of polyamic acid to form a filled polyamic acid casting solution and then cast to form a green film. This can be done with a high molecular weight polyamic acid or with a low molecular weight polyamic acid which is subsequently chain extended to a high molecular weight polyamic acid.
(i.) A method wherein the components are added in part or in whole in any order to either part or whole of the solvent, also where part or all of any component can be added as a solution in part or all of the solvent.
(j) A method of first reacting one of the dianhydride monomers with one of the diamine monomers giving a first polyamic acid, then reacting the other dianhydride monomer with the other amine component to give a second polyamic acid, and then combining the amic acids in any one of a number of ways prior to film formation.

It is preferable to use a heating system having a plurality of heating sections or zones: It is also generally preferable that the maximum heating temperature be controlled to give a maximum air (or nitrogen) temperature of the ovens from about 200 to 600°C, more preferably from 350 to 500°C. By regulating the maximum curing temperature of the green film within the range as defined above; it is possible to obtain a polyimide film that has excellent mechanical strength and good thermal dimensional stability.

Alternatively, heating temperatures can be set to 200-600°C while varying the heating time: Regarding the curing time, it is preferable that the polyimide films of the present .invention be exposed to the maximum heating temperature for about 1, 2, 3, 5, 10; 15, 20, 25, 30; 35, 40, 45 or 50 seconds to about 60, 70, 80, 90, 100,200, 400, 500, 700, 800, 900, 1000, 1100 or 1200 seconds (the length of time depending on heating temperature). The heating temperature may be changed stepwise so as not to wrinkle the film by drying to quickly.

The thickness of the polyimide film may be adjusted depending on the intended purpose of the film or final application specifications. Depending upon the design criteria of any particular embodiment chosen, the film thickness can be in a range between (and including) any two of the following film thicknesses: 5, 8, 10, 15, 20, 25, 30, 35, 40, 45, 50, 60, 80, 100, 125, 150, 175, 200, 300, 400 and 500 microns. In one embodiment, the thickness is from about 12 to about 125 microns and is preferably from 15 to 25 microns.

As used herein, the term 'thermally conductive' means a composite material possessing the physical property of being able to conduct heat at a level greater than or equal to about 0.5 watts/(meter*K) on a 1-mil film basis, and in some cases greater than 0.7 watts/(meter*K). In the case of a film, thermal conductivity is typically measured using a film sample that is about one thousands of an inch thick (~1.0 mil or 25 microns) and is round in shape (about ½ inches in diameter). The device used to measure the samples was a Netzsch® Xenon Lamp Flash Analyzer, model LFA-447 having an InSb IR sensor. The thermal conductivity reference used for these samples was a sample of Pyrex® 7740. The polyimide film composite samples were first sputtered with about 1000 angstroms of gold on both sides; then sprayed on both sides with about 1000 angstroms of graphite (to blacken the sample). The circulating bath was set at about 25°C. The wattage selection was the 'short' selection (about 304 volts) and the exposure time was about 20-30 milliseconds. To equate the thermal conductivity of the sample, the Cowan equation was used.

As used herein; the term 'dielectric strength' is a term used to describe the amount of voltage a material can withstand in short instance of time. Dielectric strength of one-mil thick, conventional, unfilled (non-corona resistant) polyimide film is typically about 7,800 volts/mil. Conventional thermally conductive films generally provide a dielectric strength of about 3,000 to 6,000 volts/mil. In one embodiment, one class of films according to the present invention is defined as having a dielectric strength greater than 5,000 volts/mil. As such, these materials are commonly referred to as a 'dielectric'.

The composites of the present invention are excellent dielectrics that can be useful in forming a polyimide-metal laminate, or may also be used as a stand-alone film in other designs requiring good thermal conductivityfrom a dielectric.

In a further embodiment, the polyamic acid filler composite slurry may be coated on a fully cured polyimide base film or directly on a metal substrate and subsequently imidized by heat treatment. The polyimide base film may be prepared by either a chemical process or thermal conversion process and may be surface treated (e.g. by chemical etching, corona treatment, laser etching etc., to improve adhesion).

A single polyimide metal-clad of the present invention comprises a flexible polyimide layer which adheres to a metal foil such as copper, aluminum, nickel, steel or an alloy containing one or more of these metals. In some cases, the polyimide composite layer can adheres firmly to the metal, having a peel strength of greater than 2 pounds per linear inch and higher, without using an additional adhesive. The metal may be adhered to one or both sides of the polyimide layer. In other cases, an adhesive can be used to laminate the polyimide film composite to a metal layer. Common adhesives are polyimide adhesive, acrytic-basedadhesives, and epoxies.

When a polyimide binder component has a Tg of about 250°C or less, the polyimide itself can act as a good adhesive film. These polyimide adhesive films can bond to copper at from about 2 pounds per linear inch to about 15 pounds per linear inch when the bonding temperature is typically between 150°C and 350°C. In one embodiment, a thermally conductive polyimide adhesive composite is bonded to copper with a bonding strength of about 8 pounds per linear inch at a bonding temperature of 200°C.

As used herein, the term "conductive layers" and "conductive foils" are meant to be metal layers or metal foils. Conductive foils are typically metal foils. Metal foils do not have to be used as elements in pure form; they may also be used as metal foil alloys, such as copper alloys containing nickel, chromium, iron, and other metals. Other useful metals include, but are not limited to, copper, steel, alurninum, brass, a copper molybdenum alloy, Kovar®, Invar®, a bimetal, a trimetal, a tri-metal derived from two-layers of copper and one layer of Invar®, and a trimetal derived from two layers of copper and one layer of molybdenum.

The conductive layers may also be metal alloys of metals and are typically applied to the polyimides of the present invention via a sputtering step, optionally followed by an electro-plating step. In these types of processes, a metal seed coat layer is first sputtered onto the polyimide adhesive. Finally, a thicker coating of metal is applied to the seed coat via electro-plating or electro-deposition. Such sputtered metal layers may also be hot pressed above the glass transition temperature of the polymer for enhanced peel strength.

A polyimide-metal laminate in accordance with the present invention may also be formed by applying a polyamic acid to metal foil, and then subsequently drying and curing the polyamic acid to form a polyimide. These single-side laminates can be laminated together (for instance where the polyimide sides are place in contact with one another) to form a double metal laminate. Particularly suitable metallic substrates are foils of rolled annealed copper (RA copper), electro-deposited copper (ED copper), or rolled annealed copper alloy. In many cases, it has proved to be of advantage to treating the metallic substrate before coating. This treatment may include, but is not limited to, electro-deposition or immersion-deposition on the metal of a thin layer of copper, zinc, chrome, tin, nickel, cobalt, other metals, and alloys of these metals. The pretreatment may consist of a chemical treatment or a mechanical roughening treatment. It has been found that this pretreatment enables the adhesion of the polymide layer and, hence, the peel strength to be further increased. Apart from roughening the surface, the chemical pretreatment may also lead to the formation of metal oxide groups, enabling the adhesion of the metal to the polyimide layer to be further increased. This pretreatment may be applied to both sides of the metal, enabling enhanced adhesion to substrates on both sides.

A polyimide metal-dad of the present invention can also be prepared by laminating copper foil to one side or both sides of an adhesive coated dielectric polyimide film. The construction can also be made by laminating adhesive coated copper foil to both sides of a dielectric polyimide film or to an adhesive coated dielectric polyimide film.

ln another embodiment, the thermally conductive polyimide composite can be a discrete layer in a multi-polyimide layer film construction. For instance, the thermally conductive layer can be coextruded as one layer in a two-layer polyimide, or as the outside layers in a three-layer polyimide (see also United States Patent No. 5,298,331, herein incorporated by reference).

In another embodiment, the polyimides of the present invention can be used as a material used to construct a planar transformer component. These planar transformer components are commonly used in power supply devices. In yet another embodiment, the polyimide adhesives of the present invention may be used with thick metal foils (like Inconel) to form flexible heaters. These heaters are typically used in automotive and aerospace applications.

Generally, the thermally conductive polyimide film composites of the present invention are useful as a single-layer base substrate (a dielectric) in an etectrohic device requiring good thermal conductivity of the dielectric material. Examples of such electronic devices include (but are not limited) thermoelectric modules, thermoelectric coolers, DC/AC and AC/DC inverters, DC/DC and AC/AC converters, power amplifiers, voltage regulators, igniters, light emitting diodes, IC packages, and the like.

The advantageous properties of this invention can be observed by reference to the following examples that illustrate, but do not limit, the invention. All parts and percentages are by weight unless other wise indicated.

The advantageous properties of this invention can be observed by reference to the following examples that illustrate, but do not limit, the invention. All parts and percentages are by weight unless other wise indicated.

### EXAMPLES

The advantageous properties of this invention can be further understood by reference to the following examples, which illustrate, but do not limit, the invention. The compounds used in the examples include:

### EXAMPLE 1

In a vessel, a polyamic acid was prepared. The polyamic acid was derived from PMDA and ODPA dianhydride, and RODA diamine. The weight percent, in DMAc, of the polyamic acid (PMDA/ODPA//RODA) was about 17 weight percent in solution. The polyamic acid solution was allowed to stir over several hours.

In another vessel, a metal oxide dispersion of alumina oxide powder was prepared in DMAc solvent. The dispersion contained about 30 weight-percent alumina oxide and about 7 weight-percent of a polyamic acid (used as a dispersing aid). The dispersion was milled in a kinetic mixer until the particles had an average particle size of approximately 1-2 microns.

The metal oxide dispersion, and additional PMDA solution at 6 weight-percent, were added to the polyamic acid blend until the weight-percent loading of alumina oxide to the polymer was approximately 56 weight-percent. This mixed polymer casting solution was homogeneously blended and then cast (using a slot-die) onto a flat metal surface to form a wet-film.

The wet-film was heated over approximately 30 minutes at a temperature of about 90°C to 150°C until the solids percent of the wet-film was about 70 weight percent. The partially dry film was peeled from the metal surface and wound onto a roll. The roll was transported to a curing oven and processed. The curing oven was used to heat the film, and put tension on the film's edges, to form a flat, polyimide film composite. The heating took place over about 20 minutes and temperature was uniformly ramped from about 250°C to about 400°C. The cured polyimide film composite had a solids percent greater than 98.5 weight percent.

The polyimide film composite was cut into half-inch circles and measured for thermal conductivity wherein the thermal conductivity was 0.6 watts/(meter*K).

### EXAMPLE 2

In a vessel, a polyamic acid was prepared. The polyamic acid was derived from PMDA and ODPA dianhydride, and RODA diamine. The weight percent, in DMAc, of the polyamic acid (PMDA/ODPA//RODA) was about 17 weight percent in solution. The polyamic acid solution was allowed to stir over several hours.

In another vessel, a metal oxide dispersion of aluminum nitride powder was prepared in DMAc solvent. The dispersion contained about 30 weight-percent alumina nitride and about 7 weight-percent of a polyamic acid (used as a dispersing aid). The dispersion was milled in a kinetic mixer until the particles had an average particle size of approximately 1-2 microns.

The metal oxide dispersion, and additional PMDA solution at 6 weight-percent, were added to the polyamic acid blend until the weight-percent loading of aluminum nitride to the polymer was approximately 50 weight-percent. This mixed polymer casting solution was homogeneously blended and then cast (using a slot-die) onto a flat metal surface to form a wet-film.

The wet-film was heated over approximately 30 minutes at a temperature of about 90°C to 150°C until the solids percent of the wet-film was about 70 weight percent. The partially dry film was peeled from the metal surface and wound onto a roll. The roll was transported to a curing oven and processed. The curing oven was used to heat the film, and put tension on the film's edges, to form a flat, polyimide film composite. The heating took place over about 20 minutes and temperature was uniformly ramped from about 250°C to about 400°C. The cured polyimide film composite had a solids percent greater than 98.5 weight percent.

The polyimide film composite was cut into half-inch circles and measured for thermal conductivity wherein the thermal conductivity was 0:9 watts/(meter*K).

### EXAMPLE 3

In a vessel, a polyamic acid was prepared. The polyamic acid was derived from PMDA and ODPA dianhydride, and RODA diamine. The weight percent, in DMAc, of the polyamic acid (PMDA/ODPA//RODA) was about 17 weight percent in solution. The polyamic acid solution was allowed to stir over several hours.

In another vessel, a dispersion of boron nitride powder was prepared in DMAc solvent. The dispersion contained about 30 weight-percent boron nitride and about 7 weight-percent of a polyamic acid (used as a dispersing aid). The dispersion was milled in a kinetic mixer until the particles had an average particle size of approximately 1-2 microns.

The powder dispersion, and additional PMDA solution at 6 weight-percent, were added to the polyamic acid blend until the weight-percent loading of boron nitride to the polymer was approximately 55 weight-percent. This mixed polymer casting solution was homogeneously blended and then cast (using a slot-die) onto a flat metal surface to form a wet-film.

The wet-film was heated over approximately 30 minutes at a temperature of about 90°C to 150°C until the solids percent of the wet-film was about 70 weight percent. The partially dry film was peeled from the metal surface and wound onto a roll. The roll was transported to a curing oven and processed. The curing oven was used to heat the film, and put tension on the film's edges, to form a flat, polyimide film composite. The heating took place over about 20 minutes and temperature was uniformly ramped from about 250°C to about 400°C. The cured polyimide film composite had a solids percent greater than 98.5 weight percent.

The polyimide film composite was cut into half-inch circles and measured for thermal conductivity wherein the thermal conductivity was 0.8 watts/(meter*K).

### EXAMPLE 4

In a vessel, a polyamic acid was prepared. The polyamic acid was derived from PMDA and 4,4'-ODA diamine. The weight percent, in DMAc, of the polyamic acid (PMDA/4;4'-ODA) was about 17 weight percent in solution. The polyamic acid solution was allowed to stir over several hours.

In another vessel, a dispersion of boron nitride powder was prepared in DMAc solvent. The dispersion contained about 30 weight-percent boron nitride and about 7 weight-percent of a polyamic acid (used as a dispersing aid). The dispersion was milled in a kinetic mixer until the particles had an average particle size of approximately 1-2 microns.

The particle dispersion, and additional PMDA solution at 6 weight-percent, were added to the polyamic acid blend until the weight-percent loading of boron nitride to the polymer was approximately 50 weight-percent. This mixed polymer casting solution was homogeneously blended and then cast (using a slot-die) onto a flat metal surface to form a wet-film.

The wet-film was heated over approximately 30 minutes at a temperature of about 90°C to 150°C until the solids percent of the wet-film was about 70 weight percent. The partially dry film was peeled from the metal surface and wound onto a roll. The roll was transported to a curing oven and processed. The curing oven was used to heat the film, and put tension on the film's edges; to form a flat, polyimide film composite. The heating took place over about 2b minutes and temperature was uniformly ramped from about 250°C to about 400°C. The cured polyimide film composite had a solids percent greater than 98.5 weight percent.

The polyimide film composite was cut into half-inch circles and measured for thermal conductivity wherein the thermal conductivity was 0.75 watts/(meter*K).

### COMPARATIVE EXAMPLE 1

In a vessel, a polyamic acid was prepared. The polyamic acid was derived from PMDA and 4,4'-ODA. The weight percent, in DMAC, of the polyamic acid (PMDA/4,4'-ODA) was about 20 weight percent in solution. The polyamic acid solution was allowed to stir over several hours.

In another vessel, a metal oxide was dispersed in DMAc. The dispersion was about 55 weight-percent alumina oxide powder. This dispersion was milled in a kinetic mixer until the particles had an average particle size of approximately 1-2 microns.

The alumina oxide metal dispersion, as well as additional PMDA solution at about 6 weight-percent solution, were added to the polyamic acid and further blended until the weight-percent loading of alumina oxide to the total polymer was approximately 35 weight-percent. This mixed polymer casting solution was relatively homogeneous and was cast (using a slot-die) onto a flat metal surface to form a wet-film.

The wet-film was heated over approximately 30 minutes at a temperature of about 90°C to 150°C until the solids percent of the wet-film was increased from about 12 weight-percent to about 70 weight-percent. The partially dry film was peeled from the metal surface and wound onto a roll.

The roll was transported to a curing oven and processed. The curing oven was used to heat the film, and put tension on the film's edges, to form a flat, cured polyimide film composite. The heating took place over about 20 minutes and the temperature was uniformly ramped from about 250°C to about 400°C. The cured polyimide film composite had a solids percent greater than 98.5 weight percent.

The polyimide film composite was cut into half-inch circles to measure the thermal conductivity, wherein the thermal conductivity was 0.4 watts/(meter*K).

### COMPARATIVE EXAMPLE 2

In a vessel, a polyamic acid was prepared. The polyamic acid was derived from PMDA and 4,4'-ODA. The weight percent, in DMAc, of the polyamic acid (PMDA/4,4'-ODA) was about 20 weight percent in solution. The polyamic acid solution was allowed to stir over several hours.

In another vessel, a metal oxide was dispersed in DMAc. The dispersion was about 25 weight-percent fumed aluminum oxide powder. This dispersion was milled in a kinetic mixer until the particles had an average particle size of approximately 0.10 microns.

The fumed oxide metal dispersion, as well as additional PMDA solution at about 6 weight-percent solution, were added to a portion of the polyamic acid and further blended until the weight-percent loading of fumed oxide to the total polymer was approximately 21 weight-percent. This mixed polymer casting solution was cast as the outer layers of a three-layer structure wherein the core layer was pure polyimide derived from PMDA/4,4'-ODA with no filler. Each layer had the same thickness and the total thickness was about 1-2 mils (or 25 to 50 microns).

The wet-film was heated over approximately 30 minutes at a temperature of about 90°C to 150°C until the solids percent of the wet-film was increased from about 12 weight-percent to about 70 weight-percent. The partially dry film was peeled from the metal surface and wound onto a roll.

The roll was transported to a curing oven and processed. The curing oven was used to heat the film, and put tension on the film's edges, to form a flat, cured polyimide film composite. The heating took place over about 20 minutes and the temperature was uniformly ramped from about 250°C to about 400°C. The cured polyimide film composite had a solids percent greater than 98.5 weight percent.

The polyimide film composite was cut into half-inch circles to measure the thermal conductivity, wherein the thermal conductivity was 0.35 watts/(meter*K).

### COMPARATIVE EXAMPLE 3

In a vessel, a polyamic acid was prepared. The polyamic acid was derived from PMDA and 4,4'-ODA. The weight percent, in DMAc, of the polyamic acid (PMDA/4,4'-ODA) was about 20 weight percent in solution. The polyamic acid solution was allowed to stir over several hours.

The wet-film was heated over approximately 30 minutes at a temperature of about 90°C to 150°C until the solids percent of the wet-film was increased from about 12 weight-percent to about 70 weight-percent. The partially dry film was peeled from the metal surface and wound onto a roll.

The roll was transported to a curing oven and processed. The curing oven was used to heat the film, and put tension on the film's edges, to form a flat, cured polyimide film composite. The heating took place over about 20 minutes and the temperature was uniformly ramped from about 250°C to about 400°C. The cured polyimide film composite had a solids percent greater than 98.5 weight percent.

The polyimide film was cut into half-inch circles to measure the thermal conductivity, wherein the thermal conductivity was 0.2 watts/(meter*K).

### COMPARATIVE EXAMPLE 4

In a vessel, a polyamic acid was prepared. The polyamic acid was derived from PMDA and BPDA with 4,4'-ODA and PPD. The weight percent, in DMAc, of the polyamic acid (PMDA/BPDA//4,4'-ODA/PPD) was about 15 weight percent in solution. The polyamic acid solution was allowed to stir over several hours.

The wet-film was heated over approximately 30 minutes at a temperature of about 90°C to 150°C until the solids percent of the wet-film was increased from about 12 weight-percent to about 70 weight-percent. The partially dry film was peeled from the metal surface and wound onto a roll.

The roll was transported to a curing oven and processed. The curing oven was used to heat the film, and put tension on the film's edges, to form a flat, cured polyimide film composite. The heating took place over about 20 minutes and the temperature was uniformly ramped from about 250°C to about 400°C. The cured polyimide film composite had a solids percent greater than 98.5 weight percent.

The polyimide film was cut into half-inch circles to measure the thermal conductivity, wherein the thermal conductivity was 0.15 watts/(meter*K).

## Claims

1. A thermally conductive polyimide film composite comprising:
A. a polyimide component derived from a dianhydride component and a diamine component wherein the diamine is selected from the group consisting of aromatic diamines, aliphatic diamines, cycloaliphatic diamines, or combinations thereof;
B. a thermally conductive filler component present in the composite an amount between and including any two of the following numbers 40, 45, 50, 55, 60, 65, 70, 75, 80 and 85 weight-percent of the film composite;
C. wherein the film composite has a thickness between and including any two of the following numbers 2, 5, 10, 15, 20, 25, 30, 35, 40, 50, 60, 70, 80, 90, 100, 150, 200, 250 and 300 microns;
D. wherein the film composite has a thermal conductivity between and including any two of the following numbers 0.5, 0.6, 0.7, 0.8, 0.9, 1.0, 1.1, 1.2, 1.3, 1.4, 1.5, 1.6, 1.7, 1.8, 1.9, 2.0, 4.0, 6.0, 8.0, 10.0, 20.0, 50.0, 100, 150 and 200 watts/(meter*K).

2. The film composite of Claim 1 wherein the diamine component is selected from the group consisting of 2,2 bis-(4-aminophenyl) propane; 4,4'-diaminodiphenyl methane; 4,4'-diaminodiphenyl sulfide (4,4'-DDS); 3,3'-diaminodiphenyl sulfone (3,3'-DDS); 4,4'-diaminodiphenyl sulfone; 4,4'-diaminodiphenyl ether (4,4'-ODA); 3,4'-diaminodiphenyl ether (3,4'-ODA); 1,3-bis- (4-aminophenoxy) benzene (APB-134 or RODA); 1,3-bis- (3-aminophenoxy) benzene (APB-133); 1,2-bis- (4-aminophenoxy) benzene; 1,2-bis- (3-aminophenoxy) benzene; 1,4-bis-(4-aminophenoxy) benzene; 1,4-bis-(3-aminophenoxy) benzene; and combinations thereof.

3. The film composite of Claim 1 wherein the diamine component is selected from the group consisting of 1,2-diaminobenzene (OPD); 1,3-diaminobenzene (MPD); 1,4-diaminobenzene (PPD); 2,5-dimethyl-1,4-diaminobenzene; 2-(trifluoromethyl)-1,4-phenylenediamine; 5-(trifluoromethyl)-1,3-phenylenediamine; 2,2-bis[4-(4-aminophenoxy)phenyl]-hexafluoropropane (BDAF); 2,2'-bis(trifluoromethyl)benzidine; 2,2-bis(3-aminophenyl) 1,1,1,3,3,3-hexafluoropropane; benzidine; 4,4'-diaminobenzophenone; 3,4'-diaminobenzophenone; 3,3'-diaminobenzophenone; and combinations thereof.

4. The film composite of Claim 1 wherein the diamine component is selected from the group consisting of 1-(4-aminophenoxy)-3-(3-aminophenoxy) benzene; 1-(4-aminophenoxy)-4-(3-aminophenoxy) benzene; 2,2-bis-[4-(4-aminophenoxy)phenyl] propane (BAPP); bis(3-aminophenyl)-3,5-di(trifluoromethyl)phenylphosphine oxide (BDAF); bis-[4-(4-aminophenoxy)phenyl] sulfone (BAPS); 2,2-bis[4-(3-aminophenoxy)phenyl] sulfone (m-BAPS); 4,4'-bis-(aminophenoxy)biphenyl (BAPB); bis-(4-[4-aminophenoxy]phenyl) ether (BAPE); 2,2'-bis-(4-aminophenyl)-hexafluoropropane (6F diamine); and combinations thereof.

5. The film composite of Claim 1 wherein the dianhydride component is selected from the group consisting of pyromellitic dianhydride (PMDA); 3,3',4,4'-biphenyl tetracarboxylic dianhydride (BPDA); 3,3',4,4'-benzophenone tetracarboxylic dianhydride (BTDA); 4,4'-oxydiphthalic anhydride (ODPA); 3,3',4,4'-diphenylsulfone tetracarboxylic dianhydride (DSDA); 2,2-bis(3,4-dicarboxyphenyl) 1,1,1,3,3;3-hexafluoroproparie dianhydride (6FDA); 4,4'-(4,4'-isopropylidenediphenoxy)bis(phthalic anhydride) (BPADA); and combinations thereof.

6. The film composite of Claim 1 wherein the dianhydride component is combination of pyromellitic diarihydride (PMDA) and 4,4'-oxydiphthalic anhydride (ODPA) and wherein the diamine component comprises a combination of p-phenylene diamine (PPD) and 1,3-bis-(4-aminophenoxy) benzene (APB-134 or RODA), and optionally hexamethylene diamine.

7. The film composite of Claim 1 wherein the dianhydride component is combination of 3,3',4,4'-biphenyltetracarboxylic dianhydride (BPDA) and 3,3'4,4'-benzophenonetetracarboxylic dianhydride (BTDA), and wherein the diamine component comprises a combination of 1,3-bis-(4-aminophenoxy) benzene (APB-134 or RODA), and hexamethylene diamine.

8. The film composite of Claim 1 wherein the thermally conductive filler component is selected from the group consisting of aluminum oxide, silica, boron nitride, boron nitride coated aluminum oxide, granular alumina, granular silica, fumed silica, silicon carbide, aluminum nitride, titanium dioxide, dicalcium phosphate, barium titanate and combinations thereof.

9. The film composite of Claim 1 wherein the polyimide component has a glass transition temperature between and including any two of the following numbers 250, 240, 230, 220, 210, 200, 190., 180, 170, 160, 150, 140, 130, 120, 110 and 100°C.
